# EUROPEAN PATENT APPLICATION

(11) **EP 3 517 649 A1**
(43) Date of publication of application: **31.07.2019**
(21) Application number: 18185294.8
(22) Date of filing: 24.07.2018
(51) Int. Cl.: C23C 14/50, C23C 14/56, C23C 16/458, C23C 16/54, H01L 21/677, H01L 31/18, C23C 16/44

(54) **FILM COATING APPARATUS**

(30) Priority: 30.01.2018 CN 201820160021 U; 30.06.2018 WO PCT/CN2018/093288
(71) Applicant: Beijing Apollo Ding Rong Solar Technology Co., Ltd., Beijing 100176 (CN)
(72) Inventor: WANG, Xiaowei, Beijing, 100176 (CN)
(74) Representative: Inchingalo, Simona

(57) **Abstract**

The present disclosure provides a film coating apparatus. In the film coating apparatus, by disposing the position sensor outside the coating chamber to detect the position of the coating carrier through the through hole and the light transmitting window of the sensor detection path, the position sensor cannot directly contact the coating carrier, so that the coating carrier cannot be damaged by the position sensor, and the position sensor cannot be influenced by the extreme environment in the coating chamber. Furthermore, by disposing the protection device in the coating chamber to protect the through hole and the light transmitting window from covering by the coating material, the normal working of the position sensor can be ensured. The film coating apparatus of the present disclosure has simple structure and low cost, and is easy to use.

## Description

### CROSS-REFERENCE TO RELATED APPLICATION

This application claims the benefit of priorities to China Patent Application No. 201820160021.3 titled "FILM COATING APPARATUS" and filed on January 30, 2018 and International Patent Application No. PCT/CN2018/093288 titled "FILM COATING APPARATUS" and filed on June 28, 2018, the contents of which are hereby incorporated by reference.

### FIELD

The present disclosure relates to the technical field of solar cell processing, especially to a film coating apparatus.

### BACKGROUND

Development and application of clean energy are becoming increasingly important with the growing problem of environmental pollution. Solar cell becomes more and more popular as a new generation of photovoltaic device to alleviate energy crisis. Physical vapor deposition (PVD) and chemical vapor deposition (CVD) are two commonly used methods in preparation of the solar cell. A PVD apparatus or a CVD apparatus used in mass production usually comprises a plurality of vacuum chambers according to technical requirements, such as a load-lock chamber, a heating chamber, a processing chamber, a cooling chamber, an unload chamber, et al. An electronic control system is used to control a vacuum system, a heating system, a cooling system, a process gas, and a transport system of the PVD apparatus or the CVD apparatus. Among those systems, the transport system is configured to transport a coating carrier, such as a glass carrier plate or a silicon wafer carrier plate. When the coating carrier arrives at a specific vacuum chamber, a position sensor sends a position signal of the coating carrier to the control system, and then the control system controls a residence time and a moving speed of the coating carrier according to the position of the coating carrier so as to control a production rhythm of the entire production line.

In the film coating apparatus such as the PVD apparatus or the CVD apparatus, a temperature can be high and sometimes can reach about 600 °C in some vacuum chambers, especially in a coating chamber (i.e. the processing chamber) in which various coating methods (such as a magnetron sputtering method, a co-evaporation method, or a plasma coating method) may be implemented. Therefore, a position and way of mounting the position sensor are very important. It is necessary to detect the position of the coating carrier when the coating carrier moves on a transport line for controlling the production rhythm and meeting the process requirement. The environment in the vacuum chamber of the film coating apparatus usually has the characteristics such as high vacuum or ultra-high vacuum; high temperature (sometimes the temperature can be about 600 °C); various coating methods are implemented and complex coating environments are resulted. Considering all the above, the position sensor can be disposed as the following ways: (1) a contact-type mechanical sensor must be mounted inside the vacuum chamber; (2) a non-contact sensor, such as a photoelectric sensor, can be mounted in the vacuum chamber; (3) the non-contact sensor, such as the photoelectric sensor, also can be mounted outside the vacuum chamber.

However, the above-described methods have some issues in practical applications.

In the method (1), the coating carrier could be damaged when contacting the contact-type mechanical sensor, thereby decreasing the coating quality. In addition, it is inconvenient to install and maintain the contact-type mechanical sensor in the vacuum chamber.

In the method (2), it is also inconvenient to install and maintain the non-contact sensor in the vacuum chamber. More importantly, almost no sensor can work in a high vacuum and high temperature environment, and even if there is any, the cost would be very high.

In the method (3), the shortcomings of the above two methods are overcome by disposing the non-contact sensor outside the vacuum chamber. However, a light path should be set through which the non-contact sensor can detect the coating carrier. A glass window on the vacuum chamber is usually provided on the light path. However, the glass window could be coated by a film during coating in the coating chamber, thereby influencing the working of the non-contact sensor.

### SUMMARY

In view of this, an object of the present disclosure is to provide a film coating apparatus to prevent a coating carrier from damaging and ensure the normal working of a sensor.

The film coating apparatus comprises:
a coating chamber;
a coating carrier disposed in the coating chamber to support a workpiece to be coated;
a position sensor disposed outside the coating chamber;
a sensor detection path communicating the position sensor and an inner of the coating chamber, wherein a position of the coating carrier is detected by the position sensor through the sensor detection path; and
a protection device disposed around the sensor detection path and extended along the sensor detection path.

In one embodiment, the protection device is a hollow cylinder having two opposite openings.

In one embodiment, the sensor detection path comprises a through hole defined on the coating chamber and a light transmitting window to seal the through hole.

In one embodiment, one end of the protection device is disposed around the through hole, and the other end of the protection device is extended from the through hole toward the inner of the coating chamber.

In one embodiment, a distance that the protection device extended from the through hole toward the inner of the coating chamber is in a range from about 50 mm to about 160 mm.

In one embodiment, the light transmitting window comprises at least one transparent glass to seal the through hole.

In one embodiment, the film coating apparatus comprises a sealing flange defining a flange hole, wherein the at least one transparent glass is disposed in the flange hole of the sealing flange, and the sealing flange is connected to the through hole.

In one embodiment, the film coating apparatus further comprises a positioning bracket disposed outside the coating chamber, wherein the position sensor is disposed on the positioning bracket.

In one embodiment, the positioning bracket is connected to the sealing flange.

In one embodiment, the through hole is disposed on the coating chamber corresponding to the position sensor.

In one embodiment, the at least one transparent glass is a high borosilicate glass.

In one embodiment, a coating source is disposed in the coating chamber, an angle between an extension direction of the protection device and a spraying direction of the coating source is in a range from about 45° to about 90°.

In one embodiment, the film coating apparatus comprises at least two position sensors, each of the at least two position sensors is correspondingly provided with one sensor detection path and one protection device.

In one embodiment, the position sensor is a photoelectric sensor.

In the film coating apparatus of the present disclosure, by disposing the position sensor outside the coating chamber to detect the position of the coating carrier through the through hole and the light transmitting window of the sensor detection path, the position sensor cannot directly contact the coating carrier, so that the coating carrier cannot be damaged by the position sensor, and the position sensor cannot be influenced by the extreme environment in the coating chamber. Furthermore, by disposing the protection device in the coating chamber to protect the through hole and the light transmitting window from covering by the coating material, the normal working of the position sensor can be ensured. The film coating apparatus of the present disclosure has simple structure and low cost, and is easy to use.

### BRIEF DESCRIPTION OF THE DRAWINGS

FIG. 1 is a schematic structural view of one embodiment of a film coating apparatus.
FIG. 2 is a partially enlarged view of A area in FIG. 1.
FIG. 3 is a side view of one embodiment of a coating chamber of the film coating apparatus.

Reference numerals respectively are:
10-coating chamber; 11-through hole; 20-coating carrier; 30-position sensor; 40-protection device; 50-positioning bracket; 60-sensor detection path; 61-light transmitting window; 70-sealing flange.

### DETAILED DESCRIPTION

In order to make the objects, technical solutions and advantages of the present disclosure to be understood more clearly, the present disclosure will be described in further details with the accompanying drawings.

Embodiments of the present disclosure will be described in more details and examples of the embodiments will be illustrated in the accompanying drawings, where same or similar reference numerals denote same or similar members or members with same or similar functions. The embodiments described herein with reference to accompanying drawings are explanatory, illustrative, and used to generally understand the present disclosure. The embodiments shall not be construed to limit the present disclosure.

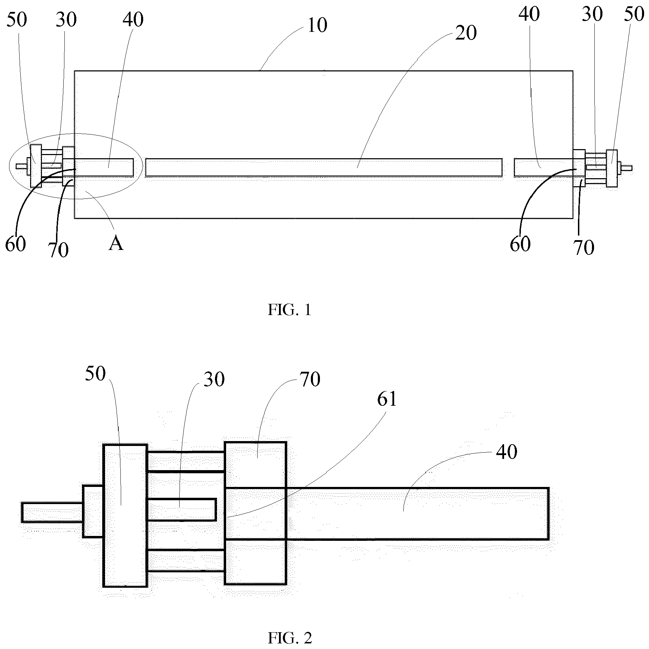

Referring to FIG. 1, one embodiment of a film coating apparatus comprises:
a coating chamber 10 comprising an inlet and an outlet for a workpiece to be coated, wherein a vacuum state can be kept in the coating chamber 10 during coating;
a coating carrier 20 disposed in the coating chamber 10 to support the workpiece to be coated;
a position sensor 30 disposed outside the coating chamber 10, wherein the position sensor 30 is configured to detect a position of the coating carrier 20 through a sensor detection path 60;
the sensor detection path 60 communicating the position sensor 30 and an inner of the coating chamber 10, wherein a detection signal sent by the position sensor 30 can enter the coating chamber 10 through the sensor detection path 60; and
a protection device 40 disposed around the sensor detection path 60 and extended along the sensor detection path 60.

In one embodiment, the protection device 40 can be a hollow cylinder having two opposite openings. The protection device 40 can be disposed in the coating chamber 10.

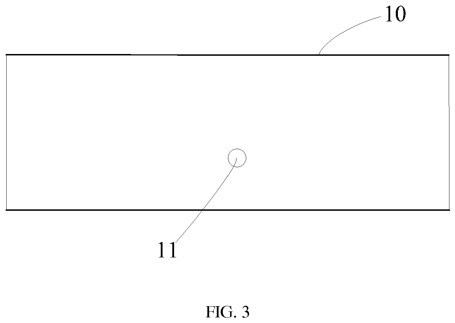

Referring to FIG. 2 and FIG. 3, in one embodiment, the sensor detection path 60 can comprise a through hole 11 defined on a sidewall of the coating chamber 10 and a light transmitting window 61 sealing the through hole 11. It should be noted that the through hole 11 can be defined on a top wall or a bottom wall of the coating chamber 10 in another embodiment. The through hole 11 can be defined in an area corresponding to the position sensor 30. In one embodiment, the light transmitting window 61 can comprise a transparent glass disposed at one end of the through hole 11 far away from the inner of the coating chamber 10.

In one embodiment, the transparent glass can be a high borosilicate glass.

In one embodiment, the film coating apparatus can further comprise a positioning bracket 50 disposed outside the coating chamber 10. The position sensor 30 can be disposed on the positioning bracket 50. The positioning bracket 50 can be configured to fix the position sensor 30.

In one embodiment, the transparent glass can be directly disposed in the through hole 11. In another embodiment, the transparent glass can be disposed at the through hole 11 by a sealing flange 70. The through hole 11 can be sealed together by the transparent glass and the sealing flange 70, so that the coating chamber 10 can be a vacuum chamber. The transparent glass can be protected by the protection device 40. In one embodiment, a first transparent glass can be disposed in a flange hole of the sealing flange 70. The sealing flange 70 can be connected to the through hole 11 to seal the through hole 11. A second transparent glass can be further disposed in the through hole 11 so that two transparent glasses can be respectively disposed in the through hole 11 and the flange hole of the sealing flange 70 to improve sealing performance of the through hole 11. The positioning bracket 50 can be further connected to the sealing flange 70 so that the position sensor 30 can be fixed conveniently.

In one embodiment, the protection device 40 can be a hollow cylinder having two opposite openings. The hollow cylinder can be disposed around the through hole 11 and extended from the through hole 11 toward the inner of the coating chamber 10. A coating source (not shown) can be disposed in the coating chamber 10. An angle between an extension direction of the protection device 40 and a spray direction of the coating source can be in a range from about 45° to about 90°. In one embodiment, the extension direction of the protection device 40 can be substantially perpendicular to the spraying direction of the coating source. An extension length of the protection device 40 can be adjusted according to the spray direction and a spray intensity of the coating source. In one embodiment, a distance that the protection device 40 extended from the through hole 11 to the inner of the coating chamber 10 can be in a range from about 50 mm to about 160 mm, such as about 155 mm.

The protection device 40 can have two openings respectively defined at two opposite ends along the extension direction. On end of the protection device 40 can be disposed at an outer periphery of an end of the through hole 11 close to the inner of the coating chamber 10. The other end of the protection device 40 can be extended toward the inner of the coating chamber 10. In one embodiment, the extension length of the protection device 40 can be about 155mm, and a diameter of the protection device 40 can be about 10mm. In one embodiment, the extension direction of the protection device 40 can be substantially perpendicular to the spraying direction of the coating source, so that the window 61 disposed at the through hole 11 can be effectively protected.

In one embodiment, the protection device 40 can be a protection cylinder. An angle between an axial direction of the protection cylinder and a movement direction of the coating carrier 20 can be in a range from about 80° to about 100°, such as about 90°, so that the position of the coating carrier 20 can be conveniently detected by the position sensor 30.

The coating chamber 10 can be a vacuum chamber. The workpiece to be coated can be disposed on the coating carrier 20 and can move with the coating carrier 20 in the vacuum chamber, during which a position of the moving coating carrier 20 can be detected by the position sensor 30, and a residence time and a moving speed of the coating carrier 20 can be controlled by a control system according to the position of the coating carrier 20. A signal sent by the position sensor 30 can be transmitted through the light transmitting window 61 and the through hole 11, so that the position of the coating carrier 20 can be detected by the position sensor 30.

In the coating process, a coating material could be sputtered onto the light transmitting window 61 and the through hole 11, and the light transmitting window 61 and the through hole 11 covered by the coating material cannot transmit signals. In the present disclosure, the signal sent by the position sensor can pass through the transmitting window 61 and the through hole 11 and then transmit toward the coating carrier 20 along the sensor detection path 60 surrounded by the protection device 40. By disposing the protection device 40 around the transmitting window 61 and the through hole 11 to increase a depth of the sensor detection path 60, the coating material cannot be sputtered onto the transmitting window 61 and the through hole 11. A material of the protection device 40 can be such as metal, polymer, and so on.

In one embodiment, a length of the protection device 40 is about 155mm and a diameter of the protection device 40 is about 10mm, by which not only the transmitting window 61 and the through hole 11 can be protected effectively, but also a raw material of the protection device 40 is saved. The axial direction of the protection device 40 is substantially perpendicular to the movement direction of the coating carrier 20, that is the axial direction of the protection device 40 is substantially perpendicular to a motion path of the coating carrier 20, by which the signal sent by the position sensor 30 cannot be blocked.

In one embodiment, the position sensor 30 can be a photoelectric sensor. The position sensor can emit a light beam. The light beam can arrive at the position of the coating carrier 20 through the sensor detection path 60.

In one embodiment, the position sensor 30 can comprise at least two position sensors 30. Each position sensor 30 can be correspondingly provided with one sensor detection path 60 and one protection device 40. A number of the position sensor 30, the sensor detection path 60, and the protection device 40 is not limited and can be disposed according to needs.

In one embodiment, the film coating apparatus can further comprise a controller connected to the position sensor 30 and the coating carrier 20 respectively. The detection of the position sensor 30 and the movement of the coating carrier 20 can be controlled by the controller.

In the film coating apparatus of the present disclosure, by disposing the position sensor 30 outside the coating chamber 10 to detect the position of the coating carrier 20 through the through hole 11 and the light transmitting window 61 of the sensor detection path 60, the position sensor 30 cannot directly contact the coating carrier 20, so that the coating carrier 20 cannot be damaged by the position sensor 30, and the position sensor 30 cannot be influenced by the extreme environment in the coating chamber 10. Furthermore, by disposing the protection device 40 in the coating chamber 10 to protect the through hole 11 and the light transmitting window 61 from being covered by the coating material, the normal working of the position sensor 30 can be ensured. The film coating apparatus of the present disclosure has a simple structure and a low cost, and is easy to use.

The structure, feature, and function of the present disclosure are described in detail above in terms of the embodiments illustrated in drawings. The above mentioned are only the preferred embodiments of the present disclosure, however, the implementation scope of the present disclosure should not be limited by the shown drawings. All obvious variations or modifications derived accordingly should be regarded as falling into the protection scope of the present disclosure.

## Claims

1. A film coating apparatus, comprising:
a coating chamber (10);
a coating carrier (20) disposed in the coating chamber (10) to support a workpiece to be coated;
a position sensor (30) disposed outside the coating chamber (10);
a sensor detection path (60) communicating the position sensor (30) and an inner of the coating chamber (10), wherein a position of the coating carrier (20) is detected by the position sensor (30) through the sensor detection path (60);
a protection device (40) disposed around the sensor detection path (60) and extended along the sensor detection path (60).

2. The film coating apparatus of claim 1, wherein the protection device (40) is a hollow cylinder having two opposite openings.

3. The film coating apparatus of any one of claims 1 to 2, wherein the sensor detection path (60) comprises a through hole (11) defined on the coating chamber (10) and a light transmitting window (61) sealing the through hole (11).

4. The film coating apparatus of claim 3, wherein one end of the protection device (40) is disposed around the through hole (11), and the other end of the protection device (40) is extended from the through hole (11) toward the inner of the coating chamber (10).

5. The film coating apparatus of claim 4, wherein a distance that the protection device (40) extended from the through hole (11) toward the inner of the coating chamber (10) is in a range from about 50mm to about 160mm.

6. The film coating apparatus of any one of claims 3 to 5, wherein the light transmitting window (61) comprises at least one transparent glass sealing the through hole (11).

7. The film coating apparatus of claim 6, further comprising a sealing flange (70) defining a flange hole, wherein the at least one transparent glass is disposed in the flange hole of the sealing flange (70), and the sealing flange (70) is connected to the through hole (11).

8. The film coating apparatus of any one of claims 1 to 7, further comprising a positioning bracket (50) disposed outside the coating chamber (10), wherein the position sensor (30) is disposed on the positioning bracket (50).

9. The film coating apparatus of claim 8, wherein the positioning bracket (50) is connected to the sealing flange (70).

10. The film coating apparatus of any one of claims 3 to 9, wherein the through hole (11) is disposed on an area of the coating chamber (10) corresponding to the position sensor (30).

11. The film coating apparatus of any one of claims 6 to 7, wherein the at least one transparent glass is a high borosilicate glass.

12. The film coating apparatus of any one of claims 1 to 11, wherein a coating source is disposed in the coating chamber (10), an angle between an extension direction of the protection device (40) and a spraying direction of the coating source is in a range from about 45° to about 90°.

13. The film coating apparatus of any one of claims 1 to 12, comprising at least two position sensors (30), each of the at least two position sensors (30) is correspondingly provided with one sensor detection path (60) and one protection device (40).

14. The film coating apparatus of any one of claims 1 to 13, wherein the position sensor (30) is a photoelectric sensor.

15. The film coating apparatus of any one of claims 1 to 14, wherein an angle between an axial direction of the protection device (40) and a movement direction of the coating carrier (20) is in a range from about 80° to about 100°.
